# EUROPEAN PATENT SPECIFICATION

(11) **EP 2 820 548 B1**
(45) Date of publication and mention of the grant of the patent: **14.12.2016**
(21) Application number: 12869720.8
(22) Date of filing: 02.03.2012
(51) Int. Cl.: G06F 12/00, G06F 11/14, G06F 12/02, G06F 11/10, G11C 11/56

(54) **VERSIONED MEMORIES USING A MULTI-LEVEL CELL**
VERSIONSBEZOGENE SPEICHER MIT EINER MEHRSTUFIGEN ZELLE
MÉMOIRES À VERSION UTILISANT UNE CELLULE À NIVEAUX MULTIPLES

(43) Date of publication of application: 07.01.2015
(73) Proprietor: Hewlett Packard Enterprise Development LP, Houston, TX 77070 (US)
(72) Inventor: YOON, Doe Hyun, Palo Alto, California 94304 (US); CHANG, Jichuan, Palo Alto, California 94304 (US); MURALIMANOHAR, Naveen, Palo Alto, California 94304 (US); SCHREIBER, Robert, Palo Alto, California 94304 (US); FARABOSCHI, Paolo, E-08174 Sant Cugat del Valles (ES); RANGANATHAN, Parthasarathy, Palo Alto, California 94304 (US)
(74) Representative: Liesegang, Eva
(86) International application number: PCT/US2012/027565
(87) International publication number: WO 2013/130106

(56) References cited:
- WO-A1-2006/065575
- WO-A2-2007/056106
- US-A- 4 459 658
- US-A- 5 410 685
- US-A1- 2005 132 250
- US-A1- 2009 089 610
- US-A1- 2009 150 599
- US-A1- 2011 029 718
- US-B2- 7 979 626

## Description

### BACKGROUND

High performance computing (HPC) systems are typically used for calculation of complex mathematical and/or scientific information. Such calculations may include simulations of chemical interactions, signal analysis, simulations of structural analysis, etc. Due to the complexity of the calculations, HPC systems may take extended periods of time to complete these calculations (e.g., hours, days, weeks, etc.). Errors such as hardware failure, application bugs, memory corruption, system faults, etc. can occur during the calculations and leave computed data in a corrupted and/or inconsistent state. When such errors occur, HPC systems restart the calculations, which could significantly increase the processing time to complete the calculations.

To reduce processing times for recalculations, checkpoints are used to store versions of calculated data at various points during the calculations. When an error occurs, the computing system restores the latest checkpoint, and resumes the calculation from the restored checkpoint. In this manner, checkpoints can be used to decrease processing times of recalculations.

Further related art may be derived from the following documents:

US 5 410 685 A discloses a non-intrusive method and system for recovering the state of a computer system including a memory having first and second matched levels. The first level is connected to a target processor and the second level is connected to a checkpoint processor which is also connected to the target processor. In particular, a two phase, non-intrusive method and system for debugging parallel computer programs is provided. The program has checkpoint instructions therein. In the first phase, the execution of the program is monitored non-intrusively from a bus connecting the target processor to the first level of memory. A sequence of relevant program instructions is stored in an event table. Upon encountering a checkpoint instruction, the target processor cues the checkpoint processor to initiate a non-intrusive checkpointing strategy utilizing the two-level memory with an E-bit scheme. More particularly, first and second locations of the first and second levels of memory, respectively, define a push down stack having a push down mode and a locked mode. The first value is transferred to the second location in the push down mode. The stack prevents any change in the first value of the at least one variable in the second location of the second level after the step of transferring in the locked mode during the execution of the instruction block. The value of the at least one variable is allowed to change in the first location of the first level during execution of the instruction block. The first value of the at least one variable contained in the second location of the second level is utilized for recovering the state of the computer system to that at the beginning of the instruction block/checkpoint frame. In the second phase, the information collected during the first phase is utilized to replay an identical execution of the program, in a simulated environment. A user, on encountering an error, can back up to a previous checkpoint and replay the program from that state of the computer system.

WO 2006/065575 A1 teaches that update data to a non-volatile memory may be recorded in at least two interleaving streams such as either into an update block or a scratch pad block depending on a predetermined condition. The scratch pad block is used to buffer update data that is ultimately destined for the update block. Synchronization information about the order recording of updates among the streams is saved with at least one of the streams. This will allow the most recently written version of data that may exist on multiple memory blocks to be identified. The synchronization information may be saved in a first block and in a write pointer that points to the next recording location in a second block. Alternatively, the synchronization information may be a time stamp.

US 4 459 658 A discloses that an operation of a computer system after a main memory failure is enabled by storing a read-only access shadow copy of its data structures in another memory having an independent failure mode. The shadow copy is periodically updated at a series of checkpoints. Where the data structure is a linked list, updating without recopying is enabled by prelinking the list item in the read-only list to the beginning of a second read/write list, which is appended to the first list at the next checkpoint.

WO 2007/056106 A2 teaches write operations that store data in different physical memory locations. Each of the physical memory locations are associated with a logical address that is shared in common among the physical addresses. Sequence information stored in the physical memory location indicates which one of the write operations occurred last. The available erased memory location can be split into a list of erased memory locations available to be used and a list of erased memory locations not available to be used. Then, on a failure, only the list of erased memory locations available to be used needs to be analyzed to reconstruct the consumption states of memory locations.

US 2011/029718 A1 is directed at a method and system to improve the performance of a multi-level cell (MLC) NAND flash memory. The metadata associated with the data stored in a MLC NAND flash memory may be stored only in one or more lower pages of the MLC NAND flash memory. The MLC NAND flash memory has lower and upper pages, where the lower pages may have a faster programming time or rate than the upper pages. By storing the metadata only in the pages of the MLC NAND flash memory that have low latencies of programming, the quality of service (QoS) of the MLC NAND flash memory can be improved.

US 2009/150599 A1 discloses a system and method for managing the storage of data in non-volatile memory. In an aspect, the data may be described by metadata and a transaction log file that are checkpointed from a volatile memory into the non-volatile memory. Actions that take place between the last checkpointing of a metadata segment and log file segment are discovered by scanning the non-volatile memory blocks, taking account of a record of the highest sector in each block that is known to have been recorded. Any later transactions are discovered and used to update the recovered metadata so that the metadata correctly represents the stored data.

US 7 979 626 B2 relates to a transaction log for flash recovery which includes a chained sequence of blocks specifying the operations that have been performed, such as a write to a sector or an erase to a block. Checkpoints are performed writing the entire flash state to flash. Once a checkpoint is performed, all of the log entries prior to the checkpoint are deleted and the log processing on recovery begins with the latest checkpoint. If the system is able to safely shutdown, then a checkpoint may be performed before the driver unloads, and on initialization, the entire persisted flash state may be loaded into the flash memory with a minimal amount of flash scanning. If a power failure occurs during system operation, then on the next boot-up, only the sectors or blocks specified in the log entries after the latest checkpoint have to be scanned, rather than all the sectors on the part.

US 2009/089610 A1 is directed at expediting recovery for crashes involving flash memory. Rather than requiring an entire flash memory to be read to reconstruct lost information, only a subset of the memory need be read thereby reducing system down time. In particular, state information such as a logical to physical mapping is periodically captured via a checkpoint operation. Moreover, a deterministic usage pattern is employed to facilitate recovery of actions performed after a checkpoint.

US 2005/132250 A1 describes a system that includes a network interface attached to a persistent memory unit. The persistent memory unit is configured to receive checkpoint data from a primary process, and to provide access to the checkpoint data for use in a backup process, which provides recovery capability in the event of a failure of the primary process. The network interface is configured to provide address translation information between virtual and physical addresses in the persistent memory unit. Alternatively, the persistent memory unit is capable of storing multiple updates to the checkpoint state. The checkpoint state and the updates to the checkpoint state, if any, can be retrieved by the backup process periodically, or all at once upon failure of the primary process.

SUMMARY OF THE INVENTION

The present invention is defined in the appended independent claims to which reference should be made. Advantageous features are out in the appended dependent claims.

### BRIEF DESCRIPTION OF THE DRAWINGS

FIG. 1 depicts example multi-level cell (MLC) non-volatile random access memory (NVRAM) configurations.
FIG. 2 is a block diagram of an example memory block using the MLC NVRAM of FIG. 1.
FIG. 3 is a block diagram of an example memory controller that may be used to implement versioned memory using the example memory block of FIG. 2.
FIG. 4 is a block diagram representing example memory states during an example computation using the example memory block of FIG. 2.
FIG. 5 is a flowchart representative of example machine-readable instructions that may be executed to implement the example memory controller of FIG. 3 to perform an example operation sequence.
FIG. 6 is a flowchart representative of example machine-readable instructions that may be executed to implement the example memory controller of FIG. 3.
FIG. 7 is a flowchart representative of example machine-readable instructions that may be executed to implement the example memory controller of FIG. 3 to perform a read operation.
FIG. 8 is a flowchart representative of example machine-readable instructions that may be executed to implement the example memory controller of FIG. 3 to perform a write operation.
FIG. 9 is a block diagram of an example processor platform capable of executing the example machine-readable instructions of FIGS. 5, 6, 7, and/or 8 to implement the example memory controller of FIG. 3.

### DETAILED DESCRIPTION

Example methods, apparatus, and articles of manufacture disclosed herein enable implementing versioned memory using multi-level cell (MLC) non-volatile random access memory (NVRAM). To implement versioned memory, examples disclosed herein utilize a global memory version number and a per-block version number to determine which level of multi-level memory cell data should be read from and/or written to. Example versioned memory techniques disclosed herein can be used to implement fast checkpointing and/or fast, atomic, and consistent data management in NVRAM.

More recent NVRAM memory technologies (e.g., phase-change memory (PCRAM), memristors, etc.) have higher memory densities than legacy memory technologies. Such higher density NVRAM memory technologies are expected to be used in newer computing systems. However, designers, engineers, and users face risks of NVRAM corruption resulting from errors such as, for example, memory leaks, system faults, application bugs, etc. As such, examples disclosed herein restore the data in the NVRAM to a stable state to eliminate or substantially reduce (e.g., minimize) the risk of corruption.

Previous systems use multi-versioned data structures, checkpoint logging procedures, etc. to enable recovery from errors. However, such multi-versioned data structures are specific to software applications designed to use those multi-versioned data structures. Thus, use of these data structures is limited to computing systems having such specifically designed software applications. In some known systems, checkpoint logging procedures rely on the ability to copy memory to a secondary location to create a checkpoint. However, copying memory may take a long period of time, and may be prone to errors as many memory operations are used to create the checkpoint. In some examples, write-ahead logging (creating logs of newly added data before updating the main data) or undo logging (creating logs of original data before overwriting the original data with new data) is used to safely update data. However, these mechanisms incur considerable overhead of performance and power.

Example methods, apparatus, and articles of manufacture disclosed herein enable checkpointing in high performance computing (HPC) systems, and provide consistent, durable, data objects in NVRAM. Examples disclosed herein implement example checkpoint operations by incrementing global memory version numbers. The global memory version number is compared against a per-block version number to determine if a memory block has been modified (e.g., modified since a previous checkpointing operation). In some examples, when the memory block has not been modified, checkpoint data is stored in a first layer of the MLC NVRAM. In some examples, when the memory block has been modified, checkpoint data is stored in a second layer of the MLC NVRAM.

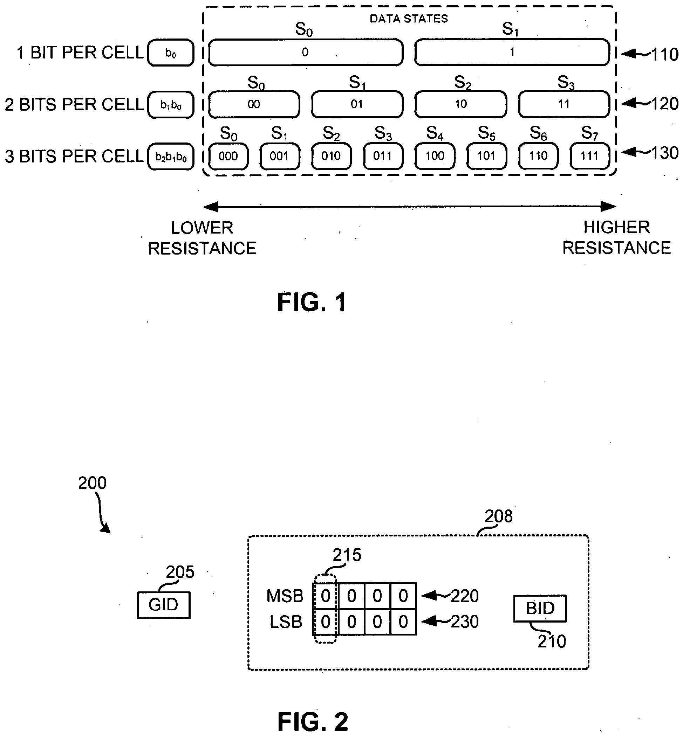

FIG. 1 depicts example multi-level cell (MLC) non-volatile random access memory (NVRAM) configurations. A first example NVRAM cell 110 stores one bit per cell (e.g., a single-level NVRAM cell having bit b₀), using a first range of resistance (e.g., low resistance values) to represent a Boolean '0' (e.g., state S₀) and a second range of resistance (e.g., high resistance values) to represent a Boolean '1' (e.g., state S₁). By dividing NVRAM cells into smaller resistance ranges as shown by example MLC NVRAM cells 120 and 130, more information may be stored, thereby, creating a higher-density memory. An example NVRAM cell 120 stores two bits per cell (e.g., four ranges of resistance to represent bits b₁ and b₀), and an example NVRAM cell 130 uses three bits per cell (e.g., eight ranges of resistance to represent bits b₂, b₁, and b₀). In the illustrated example of FIG. 1, each MLC NVRAM cell 120 and 130 stores multiple bits by using a finer-grained quantization of the cell resistance. Thus, MLC NVRAM is used to increase memory density, as more bits are stored in the same number of NVRAM cells.

Unlike other types of memory (e.g., dynamic random access memory (DRAM)), NVRAM has asymmetric operational characteristics. In particular, writing to NVRAM is more time and energy consuming than reading from NVRAM. Further, read and write operations use more memory cycles when using MLC NVRAM as compared to a single-level cell (e.g., the first example NVRAM cell 110). In MLC NVRAM, reading uses multiple steps to accurately resolve the resistance level stored in the NVRAM cell. In addition, reading the most-significant bit of an MLC (e.g., the cells 120 and 130) takes less time because the read circuitry need not determine cell resistance with the precision needed to read the least-significant bit of the MLC. Similarly, writing to a MLC NVRAM cell takes longer than a single-level cell because writing uses a serial read operation to verify that the proper value has been written to the NVRAM cell.

FIG. 2 is an example checkpointing configuration 200 shown with an example memory block 208 having four memory cells, one of which is shown at reference numeral 215. In the illustrated examples, the cells of the memory block 208 are implemented using the two-bit per cell MLC NVRAM of FIG. 1 (e.g., the NVRAM cell 120) The example checkpointing configuration 200 of FIG. 2 includes a global identifier (GID) 205 corresponding to the cells of the memory block 208 and other memory blocks not shown. The GID 205 of the illustrated example stores a global memory version number (e.g., a serial version number) representing the last checkpointed version of data stored in the memory block 208 and other memory blocks. In the illustrated example, the GID 205 is a part of a system state. That is, the GID 205 is managed, updated, and/or used in a memory as part of system control operations. In the illustrated examples disclosed herein, the GID 205 is used to denote when checkpoints occur. A checkpoint is a point during an operation of a memory at which checkpoint data used for recovery from errors, failures, and/or corruption is persisted in the memory. The GID 205 of the illustrated example is updated from time-to-time (e.g., periodically and/or aperiodically) based on a checkpointing instruction from an application performing calculations using the memory block 208 to indicate when a new checkpoint is to be stored. Additionally or alternatively, any other periodic and/or aperiodic approach to triggering creation of a checkpoint may be used. For example, a checkpoint may be created after every read and/or write operation, a checkpoint may be created after a threshold amount of time (e.g., one minute, fifteen minutes, one hour, etc.).

In the illustrated example, a single GID 205 is shown in connection with the memory block 208. However, in some examples, multiple GIDs 205 may be used to, for example, represent version numbers for different memory regions (e.g., a different GID might be used for one or more virtual address spaces such as, for example, for different processes, for one or more virtual machines, etc.). Also, in the illustrated example, a single memory block 208 is shown. However any number of memory blocks having fewer or more memory cells having the same, fewer, or more levels may be associated with the GID 205 or different respective GIDs.

In the illustrated example, a block identifier (BID) 210 is associated with the memory block 208. The BID 210 represents a version number (e.g., a serial version number) of the respective memory block 208. In the illustrated example, the BID 210 is stored in a separate memory object as metadata. In the illustrated example, a memory object is one or more memory blocks and/or locations storing data (e.g., the version number). In some examples, BIDs associated with different memory blocks may be stored in a same memory object.

As noted above, the example memory block 208 includes four multi-level cells 215, one of which is shown at reference numeral 215. However, in other examples, the memory block 208 may include any number of multi-level cells. The multi-level cell 215 of the illustrated example is a two-bit per cell MLC (e.g., such as the NVRAM cell 120 of FIG. 1) having a first level 220 (e.g., a most significant bit (MSB)) and a second level 230 (e.g., a least significant bit (LSB)). Although the multi-level cell 215 is shown as a two-bit per cell MLC, examples disclosed herein may be implemented in connection with MLCs having more than two bits per cell. Further, while in the illustrated example the first level 220 is represented by the MSB and the second level 230 is represented by the LSB, any other levels may be used to represent the MSB and/or the LSB. For example, the levels may be reversed.

In the illustrated example, the value of the BID 210 relative to the GID 205 indicates whether data stored in the memory block 208 has been modified. For example, the BID 210 can be compared to the GID 205 to determine whether data stored in the first level 220 (e.g., the MSB) or the second level 230 (e.g., the LSB) represents checkpointed data.

In the illustrated example, the GID 205 and the BID 210 are implemented using sixty-four bit counters to represent serial version numbers. When the GID 205 and/or the BID 210 are incremented beyond their maximum value, they roll back to zero. Although sixty-four bit counters are unlikely to be incremented beyond their maximum value (e.g., a rollover event) during a calculation (e.g., there will not likely be more than two to the sixty-fourth (2⁶⁴) checkpoints), when smaller counters are used (e.g., an eight bit counter, a sixteen bit counter, a thirty two bit counter, etc.) rollover events are more likely to occur as a result of the smaller counters reaching their maximum value. In the illustrated example, to prevent rollovers from causing inaccurate results from comparisons between the GID 205 and the BID 210, rollovers are detected by a memory controller. In this manner, in the event of a rollover, the memory controller can reset both the GID 205 and the BID 210 to zero. In some examples, after a rollover, the GID 205 and the BID 210 are set to different respective values (e.g., the GID 205 is set to one and the BID 210 is set to zero) to maintain accurate status of checkpoint states.

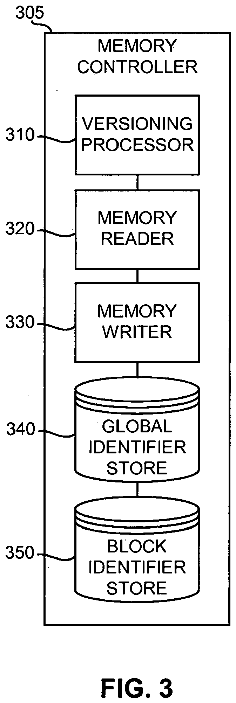

FIG. 3 is a block diagram of an example memory controller 305 that may be used to implement versioned memory using the example memory block 208 of FIG. 2. The memory controller 305 of the illustrated example of FIG. 1 includes a versioning processor 310, a memory reader 320, a memory writer 330, a global identifier store 340, and a block identifier store 340.

The example versioning processor 310 of FIG. 3 is implemented by a processor executing instructions, but it could additionally or alternatively be implemented by an application specific integrated circuit(s) (ASIC(s)), programmable logic device(s) (PLD(s)) and/or field programmable logic device(s) (FPLD(s)), and/or other circuitry. The versioning processor 310 of the illustrated example compares the GID 205 to the BID 210 for respective MLC NVRAM cells during read and write operations to determine which level of the respective MLC NVRAM cell to read and/or write to/from. In the examples disclosed herein, when the GID 205 is greater than the BID 210 write operations write to a first level of the respective MLC NVRAM cell after the data stored in the first level of the respective MLC NVRAM cell is written to a second level of the respective MLC NVRAM cell. When the GID 205 is not greater than the BID 210 write operations write to a first level of the respective MLC NVRAM cell. When the GID 205 is greater than or equal to the BID 210, read operations read data stored in the first level of the respective MLC NVRAM cell. When the GID is not greater than or equal to the BID 210, read operations read data stored in the second level of the respective MLC NVRAM cell.

The example memory reader 320 of FIG. 3 is implemented by a processor executing instructions, but could additionally or alternatively be implemented by an ASIC, DSP, FPGA, and/or other circuitry. In some examples, the example memory reader 320 is implemented by the same physical processor as the versioning processor 310. In the illustrated example, the example memory reader 320 reads from the MSB 220 or the LSB 230 of a respective memory block 208 based on the comparison of the GID 205 and the BID 210 of the respective memory block 208.

The example memory writer 330 of FIG. 3 is implemented by a processor executing instructions, but could additionally or alternatively be implemented by an ASIC, DSP, FPGA, and/or other circuitry. In some examples, the example memory writer 330 is implemented by the same physical processor as the memory reader 320 and the versioning processor 310. In the illustrated example, the example memory writer 330 writes to the MSB 220 or the LSB 230 of a respective memory block 208 based on the comparison of the GID 205 and the BID 210 of the respective memory block 208.

The example global identifier store 340 of FIG. 3 may be implemented by any tangible machine-accessible storage medium for storing data such as, for example, NVRAM flash memory, magnetic media, optical media, etc. The GID 205 may be stored in the global identifier store 340 using any data format such as, for example, binary data, comma delimited data, tab delimited data, structured query language (SQL) structures, etc. In the illustrated example, the global identifier store 340 is a sixty-four bit counter that stores the GID 205. However, any other size counter and/or data structure may additionally or alternatively be used. While in the illustrated example the global identifier store 340 is illustrated as a single data structure, the global identifier store 340 may alternatively be implemented by any number and/or type(s) of data structures. For example, as discussed above, there may be multiple GIDs 205 associated with different memory regions, each GID 205 being stored in the same global identifier store 340 and/or one or more different global identifier stores.

The example block identifier store 350 of FIG. 3 may be implemented by any tangible machine-accessible storage medium for storing data such as, for example, NVRAM flash memory, magnetic media, optical media, etc. Data may be stored in the block identifier store 350 using any data format such as, for example, binary data, comma delimited data, tab delimited data, structured query language (SQL) structures, etc. In the illustrated example, the block identifier store 350 is a sixty-four bit counter that stores the BID 210. However, any other size counter and/or data structure may additionally or alternatively be used. While in the illustrated example the block identifier store 350 is illustrated as a single data structure, the block identifier store 350 may alternatively be implemented by any number and/or type(s) of data structures.

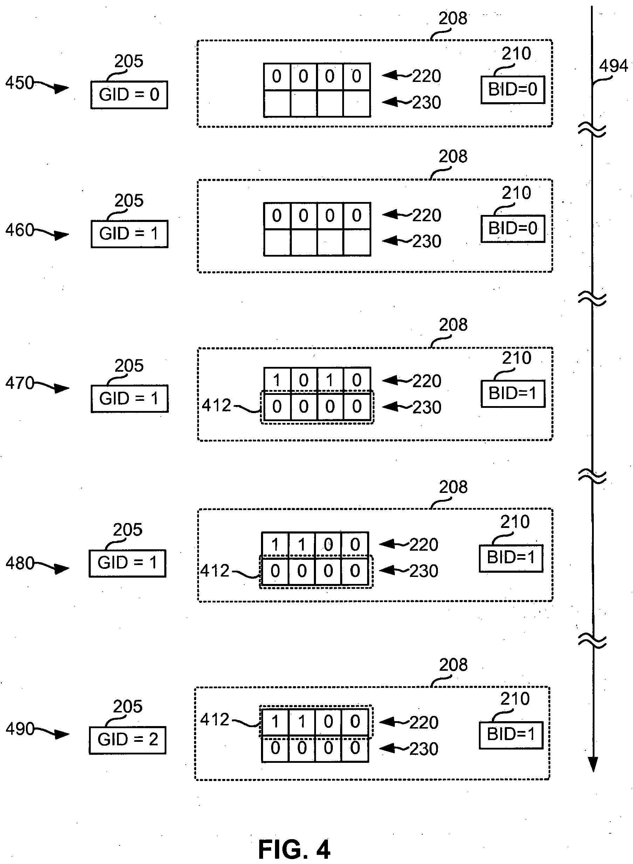

FIG. 4 is a block diagram representing example memory states 450, 460, 470, 480, and 490 of the memory block 208 of FIG. 2 during an example execution period of a computation that stores and/or updates data stored in the memory block 208. While in the illustrated example of FIG. 4 the example memory states 450, 460, 470, 480, and 490 show a progression through time as represented by an example time line 494 (with time progressing from the top of the figure downward), the durations between the different states may or may not be the same.

The example memory state 450 of the illustrated example shows an initial memory state of the memory block 208. In the illustrated example, the GID 205 and the BID 210 are set to zero, and the MSBs 220 of the illustrated memory cells (e.g., the memory cell 215 of FIG. 2) store example data of zero-zero-zero-zero. In the illustrated example, the LSBs 230 of the illustrated memory cells are blank indicating that any data may be stored in the LSB 230 (e.g., the data store in the LSB 230 is a logical don't-care).

The example memory state 460 shows the beginning of an execution period during which the GID 205 is incremented to one in response to the beginning of the execution period. In the illustrated example, the LSB 230 remains blank (e.g., not storing valid data) indicating that any data may be stored in the LSB 230 (e.g., the data store in the LSB 230 is a logical don't-care).

The example memory state 470 of the illustrated example shows an outcome of a first write operation that writes an example data value of one-zero-one-zero to the MSBs 220 of the memory block 208. In the illustrated example, because the GID 205 is greater than the BID 210 at the previous memory state 460 when the write operation is initiated, the data stored in the MSBs 220 during the memory state 460 (e.g., zero-zero-zero-zero) is written to the LSBs 230 as shown at the memory state 470. New data from the write operation initiated at the memory state 460 (e.g., one-zero-one-zero) is then written in the MSBs 220 as shown at the memory state 470. The LSBs 230 thus store the checkpointed data 412 (e.g., zero-zero-zero-zero) and the MSBs 220 store the newly written data (e.g., one-zero-one-zero). During the write operation, the BID 210 is set to the value of the GID 205, thereby preventing subsequent writes that occur before the next checkpoint (as indicated by the GID 205 and BID 210 comparison) from overwriting the checkpointed data 412.

The example memory state 480 of the illustrated example shows an outcome of a second write operation that writes example data, one-one-zero-zero, to the MSBs 220. In the illustrated example, because the GID 205 is equal to the BID 210 at the start of-the write operation, the example data, one-one-zero-zero, is written to the MSBs 220 as shown at the memory state 480, overwriting the previous data, one-zero-one-zero. As such, the LSBs 230 are not modified. When the write operation is complete at the memory state 480, the BID 210 is set to the value of the GID 205. The checkpointed data 412 remains the same in the LSBs 230 from the previous memory state 470.

The example memory state 490 of the illustrated example shows an outcome of a checkpointing operation. In the illustrated example, the checkpointing operation occurs at the end of the execution period of FIG. 4. However, the checkpointing operation may occur at a point during the execution period (e.g., after an intermediate calculation has completed). The checkpointing operation increments the GID 205. The data stored in the MSBs 220 immediately prior to the checkpointing operation represents the most recent data (e.g., data written during a calculation). As such, when the GID 205 is greater than the BID 210, the checkpointed data 412 is represented by the MSBs 220. The LSBs 230 store outdated data from the previous checkpoint. The memory modifications used in the checkpointing operation updates one value, the GID 205. Advantageously, updating the GID 205 is fast and atomic (e.g., one memory value is modified) without needing to store the ckeckpointed data 412 to another location.

While an example manner of implementing the memory controller 305 has been illustrated in FIG. 3, one or more of the elements, processes and/or devices illustrated in FIG. 3 may be combined, divided, re-arranged, omitted, eliminated and/or implemented in any other way. Further, the example versioning processor 310, the example memory reader 320, the example memory writer 330, the example global identifier store 340, the example block identifier store 350, and /or, more generally, the example memory controller 305 of FIG. 3 may be implemented by hardware, software, firmware and/or any combination of hardware, software and/or firmware. Thus, for example, any of the example versioning processor 310, the example memory reader 320, the example memory writer 330, the example global identifier store 340, the example block identifier store 350, and /or, more generally, the example memory controller 305 of FIG. 3 could be implemented by one or more circuit(s), programmable processor(s), application specific integrated circuit(s) (ASIC(s)), programmable logic device(s) (PLD(s)) and/or field programmable logic device(s) (FPLD(s)), etc. When any of the apparatus or system claims of this patent are read to cover a purely software and/or firmware implementation, at least one of the example versioning processor 310, the example memory reader 320, the example memory writer 330, the example global identifier store 340, and/or the example block identifier store 350 are hereby expressly defined to include a tangible computer readable storage medium such as a memory, DVD, CD, Blu-ray, etc. storing the software and/or firmware. Further still, the example memory controller 305 of FIG. 3 may include one or more elements, processes and/or devices in addition to, or instead of, those illustrated in FIG. 3, and/or may include more than one of any or all of the illustrated elements, processes and devices.

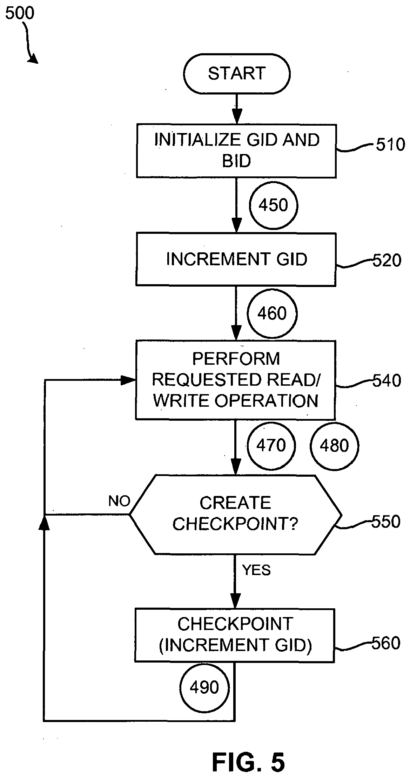

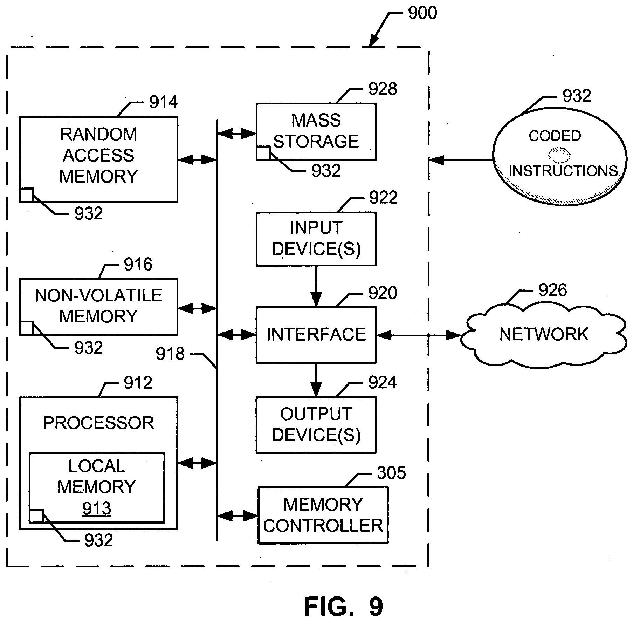

Flowcharts representative of example machine-readable instructions for implementing the memory controller 305 of FIG. 3 are shown in FIGS. 5, 6, 7, and/or 8. In these examples, the machine-readable instructions comprise one or more program(s) for execution by a processor such as the processor 912 shown in the example computer 900 discussed below in connection with FIG. 9. The program may be embodied in software stored on a tangible computer readable storage medium such as a CD-ROM, a floppy disk, a hard drive, a digital versatile disk (DVD), a Blu-ray disk, or a memory associated with the processor 912, but the entire program and/or parts thereof could alternatively be executed by a device other than the processor 912 and/or embodied in firmware or dedicated hardware. Further, although the example program is described with reference to the flowcharts illustrated in FIGS. 5, 6, 7, and/or 8 many other methods of implementing the example memory controller 305 may alternatively be used. For example, the order of execution of the blocks may be changed, and/or some of the blocks described may be changed, eliminated, or combined.

As mentioned above, the example processes of FIGS. 5, 6, 7, and/or 8 may be implemented using coded instructions (e.g., computer-readable instructions) stored on a tangible computer-readable medium such as a hard disk drive, a flash memory, a read-only memory (ROM), a compact disk (CD), a digital versatile disk (DVD), a cache, a random-access memory (RAM) and/or any other storage media in which information is stored for any duration (e.g., for extended time periods, permanently, brief instances, for temporarily buffering, and/or for caching of the information). As used herein, the term tangible computer readable storage medium is expressly defined to include any type of machine readable storage and to exclude propagating signals. Additionally or alternatively, the example processes of FIGS. 5, 6, 7, and/or 8 may be implemented using coded instructions (e.g., computer-readable instructions) stored on a non-transitory computer-readable medium such as a hard disk drive, a flash memory, a read-only memory, a compact disk, a digital versatile disk, a cache, a random-access memory and/or any other storage medium in which information is stored for any duration (e.g., for extended time periods, permanently, brief instances, for temporarily buffering, and/or for caching of the information). As used herein, the term non-transitory computer-readable medium is expressly defined to include any type of computer-readable medium and to exclude propagating signals. As used herein, when the phrase "at least" is used as the transition term in a preamble of a claim, it is open-ended in the same manner as the term "comprising" is open ended. Thus, a claim using "at least" as the transition term in its preamble may include elements in addition to those expressly recited in the claim.

FIG. 5 is a flowchart representative of example machine-readable instructions that may be executed to implement the example memory controller 305 of FIG. 3 to perform memory accesses and checkpoint operations. In the illustrated example of FIG. 5, circled reference numerals denote example memory states (e.g., the example memory states of FIG. 4) at various points during the execution period. The example operation sequence 500 begins at block 520. In the illustrated example, prior to block 520, the memory block 208 is at the memory state 450 of FIG. 4 at which no checkpointing has occurred. Because checkpointing has not yet occurred, the GID 205 and the BID 210 of FIGS. 2 and 4 are zero.

Initially, the versioning processor 310 of FIG. 3 initializes the GID 205 and the BID 210 (block 510). In the illustrated example, the GID 205 and the BID 210 are set to zero, however any other value may be used. An example memory state representing the initialized GID 205 and BID 210 is shown in the example memory state 450 of FIG. 4.

The versioning processor 310 increments the GID 205 (block 520). By incrementing the GID 205, a subsequent write operation to the memory block 208 causes the data stored in the MSB 220 to be stored in the LSB 230 as checkpoint data 412 of FIG. 4. An example memory state representing the incremented GID 205 prior to read and/or write operations is shown in the example memory state 460 of FIG. 4.

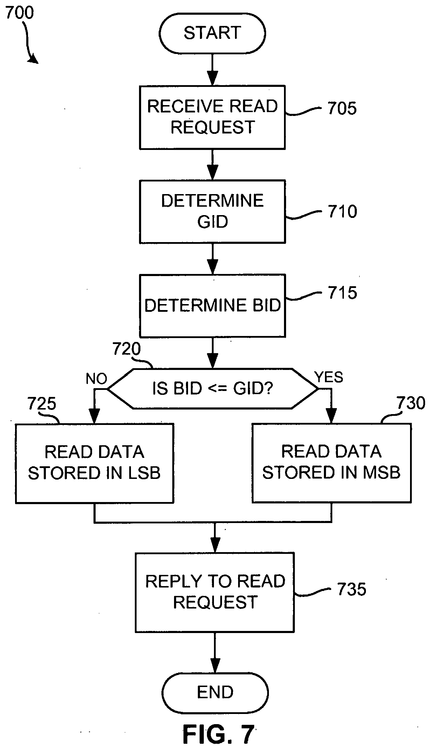

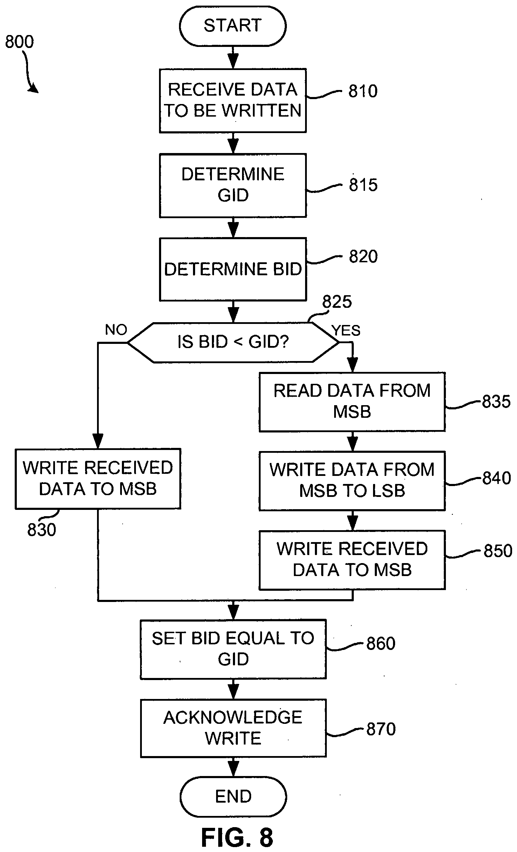

The memory controller 305 performs a requested read and/or write operation on the memory block 208 (block 540). Read operations are discussed in further detail in connection with FIG. 7. Write operations are discussed in further detail in connection with FIG. 8.

In the illustrated example, a first write request is received and processed. The outcome of the first write request is shown in the example memory state 470 of FIG. 4. In the illustrated example, the first write request indicates new data (e.g., one-zero-one-zero) to be written. Based on a comparison of the GID 205 and the BID 210, the versioning processor 310 causes the memory reader 320 to read the MSBs 220 and the memory writer 330 to write the data read from the MSBs 220 to the LSBs 230. The memory writer 330 then writes the new data to the MSBs 220. The versioning processor 310 sets the BID 210 equal to the GID 205.

The versioning processor 310 determines if a checkpoint should be created (block 550). In the illustrated example, a checkpoint is created in response to a received checkpoint request. In some examples, the versioning processor 310 receives a request to create a checkpoint from an application that requests the read and/or write operations of block 540. Additionally or alternatively, any other periodic and/or aperiodic approach to triggering creation of a checkpoint may be used. For example, the versioning processor 310 may create the checkpoint after every read and/or write operation, the versioning processor 310 may create the checkpoint after an amount of time (e.g., one minute, fifteen minutes, one hour, etc.).

If the versioning processor 310 is not to create a checkpoint, control returns to block 540 where the memory controller 305 performs another requested read and/or write operation on the memory block 208 (block 540). In the illustrated example, a second write request is received and processed (block 540). The outcome of the second write request is shown in the example memory state 480 of FIG. 4. In the illustrated example, the second write request indicates new data to be written (e.g., one-one-zero-zero). Because the first write operation set the BID 210 equal to the GID 205, the versioning processor 310 causes the memory writer 330 to write the data to the MSB 220. The LSB 230 is not modified. The versioning processor 310 sets the BID 210 equal to the GID 205.

Returning to block 550, when a checkpoint is to be created, the versioning processor 310 increments the GID 205 (block 560). An example outcome of the incrementation of the GID 205 is shown in the example memory state 490 of FIG. 4. Control then proceeds to block 540 where a first subsequent (e.g., the next) write operation causes the memory controller 305 to copy the data from the MSB 220 to the LSB 230 (e.g., as in the example memory state of 470) to persist as the checkpoint data 412 of FIG. 4.

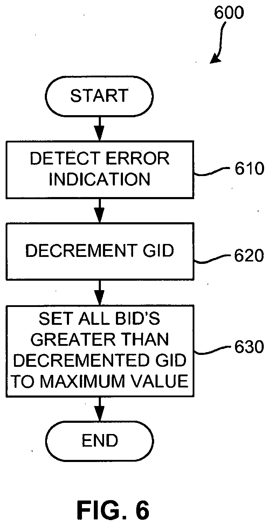

FIG. 6 is a flowchart representative of example machine-readable instructions 600 that may be executed to implement the example memory controller of FIG. 3 to recover from an error (e.g., a failure, a fault, etc.). The example process 600 of FIG. 6 begins when the versioning processor 310 detects an error indication (block 610). In the illustrated example, the error indication is received from an application performing calculations on the data in the memory block 208. However, any other way of detecting the error indication may additionally or alternatively be used such as, for example, detecting when a system error has occurred, detecting an application crash, etc.

When the error indication is detected, the versioning processor 310 decrements the GID 205 (e.g., the previous GID value) (block 620). While in the illustrated example, the GID 205 is set to zero, any other value may additionally or alternatively be used in response to an error. The versioning processor 310 then inspects the BIDs 210 associated with each memory block 208 and sets each BID 210 whose value is greater than the GID 205 (after decrementing) to a maximum value (e.g., two to the sixty-fourth minus one) (block 630). However, the BID 210 may be set to any other value.

After the versioning processor 330 resets the GID 205 and the BID 210, subsequent read operations read data from the LSBs 230. Subsequent write operations write data to the MSBs 220 and set the BID 210 to a value of the GID 205.

FIG. 7 is a flowchart representative of example machine-readable instructions 700 that may be executed to implement the example memory controller 305 of FIG. 3 to perform a read operation on the memory block 208 of FIG. 2. The example process 700 begins when the versioning processor 310 receives a read request for a particular memory block 208 (block 705). The versioning processor 310 determines the GID 205 (block 710). In the illustrated example, the versioning processor 310 determines the GID 205 by reading the GID 205 from the global identifier store 340. The versioning processor 310 determines the BID 210 associated with the memory block 208 (block 715). In the illustrated example, the versioning processor 310 determines the BID 210 by reading the BID 210 from the block identifier store 350.

The versioning processor 310 compares the GID 205 to the BID 210 to identify which level of the memory block 208 should be read (block 720). In the illustrated example, the versioning processor 310 determines that a first layer of the memory block 208 (e.g., the MSBs 220) should be read when the BID 210 is less than or equal to the GID 205. The memory reader 320 then reads the data stored in the first layer (block 730). If the versioning processor 310 determines that the BID 210 is greater than the GID 205, the memory reader 320 reads the data stored in a second layer (e.g., the LSBs 230) (block 725).

Once the memory reader 320 has read the data from the appropriate layer, the memory reader 320 replies to the read request with the data (block 735).

FIG. 8 is a flowchart representative of example machine-readable instructions 800 that may be executed to implement the example memory controller of FIG. 3 to perform a read operation on the memory block 208 of FIG. 2. The example process 800 begins when the versioning processor 310 receives a write request for a particular memory block 208 (block 810). The write request includes an address of the memory block 208, and data to be written to the memory block 208. The versioning processor 310 determines the GID 205 (block 815). In the illustrated example, the versioning processor 310 determines the GID 205 by reading the GID 205 from the global identifier store 340. The versioning processor 310 determines the BID 210 associated with the memory block 208 (block 820). In the illustrated example, the versioning processor 310 determines the BID 210 by reading the BID 210 from the block identifier store 350. The versioning processor 310 compares the GID 205 to the BID 210 to identify which level of the memory block 208 to which the received data should be written (block 825).

In the illustrated example, if the BID 210 is less than the GID 205, the memory reader 320 reads a current data from a first layer (e.g., the MSBs 220) of the memory block 208 (block 835). The memory writer 330 then writes the current data read from the first layer to a second layer (e.g., the LSBs 230) of the memory block 208 (block 840). The memory writer then writes the received data to the first layer (e.g., the MSBs 220) of the memory block 208 (block 850).

Returning to block 825, if the BID 210 is greater than or equal to the GID 205, the memory writer 330 writes the received data to the first layer (e.g., the MSBs 220) of the memory block 208 (block 830).

After writing the received data to the appropriate layer, the versioning processor 310 sets the BID 210 associated with the memory block 208 to a value of the GID 205 (block 860). Thus, in the illustrated example, blocks 835, 840, and 850 are executed in association with a first write operation after a checkpointing operation. In the illustrated example, block 830 is executed in association with subsequent write operations. The versioning processor 310 then acknowledges the write request (block 870).

FIG. 9 is a block diagram of an example computer 900 capable of executing the example machine-readable instructions of FIGS. 5, 6, 7, and/or 8 to implement the example memory controller of FIG. 3. The computer 900 can be, for example, a server, a personal computer, a mobile phone (e.g., a cell phone), a personal digital assistant (PDA), an Internet appliance, or any other type of computing device.

The system 900 of the instant example includes a processor 912. For example, the processor 912 can be implemented by one or more microprocessors or controllers from any desired family or manufacturer.

The processor 912 includes a local memory 913 (e.g., a cache) and is in communication with a main memory including a volatile memory 914 and a non-volatile memory 916 via a bus 918. The volatile memory 914 may be implemented by Synchronous Dynamic Random Access Memory (SDRAM), Dynamic Random Access Memory (DRAM), RAMBUS Dynamic Random Access Memory (RDRAM) and/or any other type of random access memory device. The non-volatile memory 916 of the illustrated example is implemented by multi-level cell (MLC) non-volatile random access memory (NVRAM). The non-volatile memory 916 may be implemented by any other desired type of memory device (e.g., flash memory, phase-change memory (PCRAM), memristors, etc.). Access to the main memory 914, 916 is controlled by the memory controller 305. In the illustrated example, the memory controller 305 communicates with the processor 912 via the bus 918. In some examples, the memory controller 305 is implemented via the processor 912. In some examples, the memory controller 305 is implemented via the non-volatile memory 916. The volatile memory 914 and/or the non-volatile memory 916 may implement the global identifier store 340 and/or the block identifier store 350.

The computer 900 also includes an interface circuit 920. The interface circuit 920 may be implemented by any type of interface standard, such as an Ethernet interface, a universal serial bus (USB), and/or a PCl express interface.

One or more input devices 922 are connected to the interface circuit 920. The input device(s) 922 permit a user to enter data and commands into the processor 912. The input device(s) can be implemented by, for example, a keyboard, a mouse, a touchscreen, a track-pad, a trackball, isopoint and/or a voice recognition system.

One or more output devices 924 are also connected to the interface circuit 920. The output devices 924 can be implemented, for example, by display devices (e.g., a liquid crystal display, a cathode ray tube display (CRT), a printer and/or speakers). The interface circuit 920, thus, typically includes a graphics driver card.

The interface circuit 920 also includes a communication device such as a modem or network interface card to facilitate exchange of data with external computers via a network 926 (e.g., an Ethernet connection, a digital subscriber line (DSL), a telephone line, coaxial cable, a cellular telephone system, etc.).

The computer 900 also includes one or more mass storage devices 928 for storing software and data. Examples of such mass storage devices 928 include floppy disk drives, hard drive disks, compact disk drives and digital versatile disk (DVD) drives. The mass storage device 928 may implement the global identifier store 340 and/or the block identifier store 350.

The coded instructions 932 of FIGS. 5, 6, 7, and/or 8 may be stored in the mass storage device 928, in the volatile memory 914, in the non-volatile memory 916, in the local memory 913, and/or on a removable storage medium such as a CD or DVD.

From the foregoing, it will be appreciated that the above disclosed methods, apparatus and articles of manufacture enable versioned memory using multi-level (MLC) non-volatile random access memory (NVRAM). Advantageously, the versioning is implemented using minimal memory management operations. As such, checkpointing enables fast, and atomic/consistent data management in NVRAM. Further, recovery from an error (e.g., a memory corruption, a system crash, etc.) is fast, as a minimal amount of memory locations are modified during recovery.

Although certain example methods, apparatus and articles of manufacture have been described herein, the scope of coverage of this patent is not limited thereto. On the contrary, this patent covers all methods, apparatus and articles of manufacture fairly falling within the scope of the claims of this patent.

## Claims

1. A method of implementing a versioned memory consisting of a plurality of memory blocks (208) using a multi-level cell (120, 130, 215), the method comprising:
comparing, with a processor (310), a global memory version (205) to a block memory version (210), the global memory version (205) corresponding to the plurality of memory blocks (208), the block memory version (210) corresponding to one of the plurality of memory blocks (208); and
based on the comparison, determining which level (220, 230) in a multi-level cell (120, 130, 215) of the one of the plurality of memory blocks (208) stores checkpoint data.

2. The method as described in claim 1, further comprising writing received data to a first level (220) of the multi-level cell (120, 130, 215) when a second level (230) of the multi-level cell (120, 130, 215) stores the checkpoint data.

3. The method as described in claim 1, further comprising:
writing first data stored in a first level (220) of the multi-level cell (120, 130, 215) to a second level (230) of the multi-level cell (120, 130, 215);
after writing the first data to the second level (230) of the multi-level cell (120, 130, 215), writing received data to the first level (220) of the multi-level cell (120, 130, 215); and
setting the block memory version (210) to the value of the global memory version (205).

4. The method as described in claim 1, further comprising:
detecting an error state of data stored in the multi-level cell (120, 130, 215); and
reading data stored in a checkpoint level of the multi-level cell (120, 130, 215) to recover from the error state.

5. An apparatus (305) to implement a versioned memory consisting of a plurality of memory blocks (208) using a multi-level cell (120, 130, 215), the apparatus (305) comprising:
a global identifier store (340) to store a global memory version (205), the global memory version (205) corresponding to the plurality of memory blocks (208);
a block identifier store (350) to store a block memory version (210), the block memory version (210) corresponding to one of the plurality of memory blocks (208); and
a versioning processor (310) to compare the global memory version (205) to the block memory version (210) to determine which level (220, 230) in a multi-level cell (120, 130, 215) of the one of the plurality of memory blocks (208) is to store checkpoint data.

6. The apparatus (305) as described in claim 5, further comprising a memory writer (330) to, when data stored in a first level (220) of the multi-level cell (120, 130, 215) stores the checkpoint data:
write first data stored in the first level (220) of the multi-level cell to a second level (230) of the multi-level cell (120, 130, 215);
write received data in the first level (220) of the multi-level cell (120, 130, 215) after the first data is written to the second level (230) of the multi-level cell (120, 130, 215); and
set the block memory version (210) to the value of the global memory version (205).

7. The apparatus (305) as described in claim 5, further comprising a memory writer (330) to, when data stored in a first level (220) of the multi-level cell (120, 130, 215) does not store the checkpoint data, write received data to the first level (220) of the multi-level cell (120, 130,215).

8. The apparatus (305) as described in claim 5, wherein the versioning processor (310) is to compare the block memory version (210) to the global memory version (205) to determine if a computing error has occurred in association with first data stored in the first level (220) of the multi-level cell.

9. The apparatus (305) as described in claim 8, further comprising a memory reader (320) to read second data from a second level (230) of the multi-level cell (120, 130, 215) when the computing error has occurred.

10. The apparatus (305) as described in claim 8, further comprising a memory reader (320) to read the first data from the first level (220) of the multi-level cell (120, 130, 215) when the computing error has not occurred.

11. A tangible computer-readable storage medium comprising instructions which, when executed, cause a computer to:
compare, with a processor (310), a global memory version (205) to a block memory version (210), the global memory version (205) corresponding to a plurality of memory blocks (208) of a versioned memory using a multi-level cell (120, 130, 215), the block memory version (210) corresponding to one of the plurality of memory blocks (208); and
determine, based on the comparison, which level (220, 230) in a multi-level cell (120, 130, 215) of the one of the plurality of memory blocks (208) stores checkpoint data.

12. The machine-readable medium as described in claim 11, further storing instructions which cause the computer to write received data to a first level (220) of the multi-level cell (120, 130, 215) when a second level (230) of the multi-level cell (120, 130, 215) stores the checkpoint data.

13. The machine-readable medium as described in claim 11, further storing instructions which cause the computer to at least:
write first data stored in a first level (220) of the multi-level cell (120, 130, 215) to a second level of the multi-level cell (120, 130, 215);
write received data to the first level (220) of the multi-level cell (120, 130, 215) after writing the first data to the second level (230) of the multi-level cell (120, 130, 215); and
set the block memory version (210) to the value of the global memory version (205).

14. The machine-readable medium as described in claim 11, further storing instructions which cause the computer to at least:
detect an error state of data stored in the multi-level cell (120, 130, 215); and
read data stored in a checkpoint level of the multi-level cell (120, 130, 215) to recover from the error state.

## Patentansprüche

1. Verfahren zum Implementieren eines versionierten Speichers, bestehend aus mehreren Speicherblöcken (208), unter Einsatz einer MLC-Speicherzelle (multi-level cell) (120, 130, 215), wobei das Verfahren Folgendes umfasst:
Vergleichen einer globalen Speicherversion (205) mit einer Blockspeicherversion (210) mittels eines Prozessors (310), wobei die globale Speicherversion (205) den mehreren Speicherblöcken (208) entspricht, wobei die Blockspeicherversion (210) einem der mehreren Speicherblöcke (208) entspricht; und
basierend auf dem Vergleich Bestimmen, in welchem Level (220, 230) in einer MLC-Speicherzelle (120, 130, 215) des einen der mehreren Speicherblöcke (208) Prüfpunktdaten gespeichert sind.

2. Verfahren nach Anspruch 1, ferner umfassend ein Schreiben von empfangenen Daten in ein erstes Level (220) der MLC-Speicherzelle (120, 130, 215), wenn in einem zweiten Level (230) der MLC-Speicherzelle (120, 130, 215) die Prüfpunktdaten gespeichert sind.

3. Verfahren nach Anspruch 1, ferner Folgendes umfassend:
Schreiben erster in einem ersten Level (220) der MLC-Speicherzelle (120, 130, 215) gespeicherter Daten in ein zweites Level (230) der MLC-Speicherzelle (120, 130, 215); nach dem Schreiben der ersten Daten in das zweite Level (230) der MLC-Speicherzelle (120, 130, 215) Schreiben empfangener Daten in das erste Level (220) der MLC-Speicherzelle (120, 130, 215); und
Setzen der Blockspeicherversion (210) auf den Wert der globalen Speicherversion (205).

4. Verfahren nach Anspruch 1, ferner Folgendes umfassend:
Erkennen eines Fehlerzustands von in der MLC-Speicherzelle (120, 130, 215) gespeicherten Daten; und
Auslesen von in einem Prüfpunktlevel der MLC-Speicherzelle (120, 130, 215) gespeicherten Daten, um eine Wiederherstellung aus dem Fehlerzustand auszuführen.

5. Vorrichtung (305) zum Implementieren eines versionierten Speichers, bestehend aus mehreren Speicherblöcken (208), unter Einsatz einer MLC-Speicherzelle (120, 130, 215), wobei die Vorrichtung (305) Folgendes umfasst:
einen Speicher für globale Bezeichner (340) zum Speichern einer globalen Speicherversion (205), wobei die globale Speicherversion (205) den mehreren Speicherblöcken (208) entspricht;
einen Speicher für Blockbezeichner (350) zum Speichern einer Blockspeicherversion (210), wobei die Blockspeicherversion (210) einem der mehreren Speicherblöcke (208) entspricht; und
einen Versionierungsprozessor (310) zum Vergleichen der globalen Speicherversion (205) mit der Blockspeicherversion (210), um zu bestimmen, welches Level (220, 230) in einer MLC-Speicherzelle (120, 130, 215) des einen der mehreren Speicherblöcke (208) zum Speichern von Prüfpunktdaten vorgesehen ist.

6. Vorrichtung (305) nach Anspruch 5, ferner umfassend eine Speicherschreibvorrichtung (330), um dann, wenn in einem ersten Level (220) der MLC-Speicherzelle (120, 130, 215) gespeicherte Daten die Prüfpunktdaten speichern, Folgendes auszuführen:
Schreiben erster in einem ersten Level (220) der MLC-Speicherzelle gespeicherter Daten in ein zweites Level (230) der MLC-Speicherzelle (120, 130, 215);
Schreiben empfangener Daten in dem ersten Level (220) der MLC-Speicherzelle (120, 130, 215), nachdem die ersten Daten in das zweite Level (230) der MLC-Speicherzelle (120, 130, 215) geschrieben worden sind; und
Setzen der Blockspeicherversion (210) auf den Wert der globalen Speicherversion (205).

7. Vorrichtung (305) nach Anspruch 5, ferner umfassend eine Speicherschreibvorrichtung (330), um dann, wenn in einem ersten Level (220) der MLC-Speicherzelle (120, 130, 215) gespeicherte Daten nicht die Prüfpunktdaten speichern, empfangene Daten in das erste Level (220) der MLC-Speicherzelle (120, 130, 215) zu schreiben.

8. Vorrichtung (305) nach Anspruch 5, wobei der Versionierungsprozessor (310) dafür vorgesehen ist, die Blockspeicherversion (210) mit der globalen Speicherversion (205) zu vergleichen, um zu bestimmen, ob ein Berechnungsfehler in Verbindung mit ersten in dem ersten Level (220) der MLC-Speicherzelle gespeicherten Daten aufgetreten ist.

9. Vorrichtung (305) nach Anspruch 8, ferner umfassend eine Speicherlesevorrichtung (320) zum Auslesen von zweiten Daten aus einem zweiten Level (230) der MLC-Speicherzelle (120, 130, 215), wenn der Berechnungsfehler aufgetreten ist.

10. Vorrichtung (305) nach Anspruch 8, ferner umfassend eine Speicherlesevorrichtung (320) zum Auslesen der ersten Daten aus dem ersten Level (220) der MLC-Speicherzelle (120, 130, 215), wenn der Berechnungsfehler nicht aufgetreten ist.

11. Materielles computerlesbares Speichermedium, umfassend Anweisungen, die, wenn sie ausgeführt werden, bewirken, dass ein Computer Folgendes ausführt:
Vergleichen einer globalen Speicherversion (205) mit einer Blockspeicherversion (210) mittels eines Prozessors (310), wobei die globale Speicherversion (205) mehreren Speicherblöcken (208) eines versionierten Speichers, der eine MLC-Speicherzelle (120, 130, 215) verwendet, entspricht, wobei die Blockspeicherversion (210) einem der mehreren Speicherblöcke (208) entspricht; und
basierend auf dem Vergleich Bestimmen, in welchem Level (220, 230) in einer MLC-Speicherzelle (120, 130, 215) des einen der mehreren Speicherblöcke (208) Prüfpunktdaten gespeichert sind.

12. Maschinenlesbares Medium nach Anspruch 11, ferner Anweisungen speichernd, die bewirken, dass der Computer empfangene Daten in ein erstes Level (220) der MLC-Speicherzelle (120, 130, 215) schreibt, wenn in einem zweiten Level (230) der MLC-Speicherzelle (120, 130, 215) die Prüfpunktdaten gespeichert sind.

13. Maschinenlesbares Medium nach Anspruch 11, ferner Anweisungen speichernd, die bewirken, dass der Computer wenigstens Folgendes ausführt:
Schreiben erster in einem ersten Level (220) der MLC-Speicherzelle (120, 130, 215) gespeicherter Daten in ein zweites Level der MLC-Speicherzelle (120, 130, 215); Schreiben empfangener Daten in das erste Level (220) der MLC-Speicherzelle (120, 130, 215) nach dem Schreiben der ersten Daten in das zweite Level (230) der MLC-Speicherzelle (120, 130, 215); und
Setzen der Blockspeicherversion (210) auf den Wert der globalen Speicherversion (205).

14. Maschinenlesbares Medium nach Anspruch 11, ferner Anweisungen speichernd, die bewirken, dass der Computer wenigstens Folgendes ausführt:
Erkennen eines Fehlerzustands von in der MLC-Speicherzelle (120, 130, 215) gespeicherten Daten; und
Auslesen von in einem Prüfpunktlevel der MLC-Speicherzelle (120, 130, 215) gespeicherten Daten, um eine Wiederherstellung aus dem Fehlerzustand auszuführen.

## Revendications

1. Procédé de mise en oeuvre d'une mémoire à version constituée d'un ensemble de blocs de mémoire (208) utilisant une cellule à niveaux multiples (120, 130, 215), le procédé comprenant :
la comparaison, avec un processeur (310), d'une version de mémoire globale (205) à une version de mémoire à blocs (210), la version globale de mémoire (205) correspondant à la pluralité de blocs mémoire (208), la version de mémoire à blocs (210) correspondant à un bloc mémoire de la pluralité de blocs mémoire (208) ; et
en fonction de la comparaison, la détermination du niveau (220, 230) dans une cellule à niveaux multiples (120, 130, 215) d'un des blocs mémoires de la pluralité de blocs mémoire (208) qui stocke les données de point de contrôle.

2. Procédé selon la revendication 1, comprenant en outre l'écriture des données reçues à un premier niveau (220) de la cellule à niveaux multiples (120, 130, 215) quand un deuxième niveau (230) de la cellule à niveaux multiples (120, 130, 215) enregistre les données de point de contrôle.

3. Procédé selon la revendication 1, comprenant en outre:
l'écriture des premières données enregistrées dans un premier niveau (220) de la cellule à niveaux multiples (120, 130, 215) vers un deuxième niveau (230) de la cellule à niveaux multiples (120, 130, 215) :
après l'écriture des premières données vers le deuxième niveau (230) de la cellule à niveaux multiples (120, 130, 215), l'écriture de données vers le premier niveau (220) de la cellule à niveaux multiples (120, 130, 215) ; et
le réglage de la version de mémoire à blocs (210) à la valeur de la version de mémoire globale (205).

4. Procédé selon la revendication 1, comprenant en outre:
la détection d'un état d'erreur de données enregistrées dans la cellule à niveaux multiples (120, 130, 215) ; et
la lecture de données enregistrées dans la cellule à niveaux multiples (120, 130, 215) pour récupérer depuis l'état d'erreur.

5. Appareil (305) servant à mettre en oeuvre une mémoire à version constituée d'un ensemble de blocs de mémoire (208) utilisant une cellule à niveaux multiples (120, 130, 215), l'appareil (305) comprenant :
un magasin global d'identification (340) servant à enregistrer une version globale de mémoire (205), la version globale de mémoire (205) correspondant à la pluralité de blocs mémoire (208) ;
un magasin d'identification de blocs (350) servant à stocker une version de mémoire à blocs (210), la version de mémoire à blocs (210) correspondant à un des blocs mémoire de la pluralité de blocs mémoire (208) ; et
un processeur de choix de version (310) servant à comparer la version globale de mémoire (205) à la version de mémoire à blocs (210) pour déterminer le niveau (220, 230) d'une cellule à niveaux multiples (120, 130, 215) d'un des blocs mémoire de la pluralité de blocs mémoire (208) doit enregistrer des données de point de contrôle.

6. Appareil (305) selon la revendication 5, comprenant en outre un scripteur de mémoire (330) qui, quand les données enregistrées dans un premier niveau (220) de la cellule à niveaux multiples (120, 130, 215), enregistre les données de point de contrôle :
écrire les premières données enregistrées dans le premier niveau (220) de la cellule à niveaux multiples vers un deuxième niveau (230) de la cellule à niveaux multiples (120, 130, 215) ;
écrire les données reçues dans le premier niveau (220) de la cellule à niveaux multiples (120, 130, 215) une fois que les premières données sont écrites dans le deuxième niveau (230) de la cellule à niveaux multiples (120, 130, 215) ; et
régler la version de mémoire à blocs (210) à la valeur de la version de mémoire globale (205).

7. Appareil (305) selon la revendication 5, comprenant en outre un scripteur de mémoire (330) qui, quand les données enregistrées dans un premier niveau (220) de la cellule à niveaux multiples (120, 130, 215), n'enregistre pas les données de point de contrôle, écrit les données reçues dans le premier niveau (220) de la cellule à niveaux multiples (120, 130, 215).

8. Appareil (305) selon la revendication 5, dans lequel le processeur de choix de version (310) compare la version de mémoire à blocs (210) à la version de mémoire globale (205) pour déterminer si une erreur de calcul a eu lieu en lien avec les premières données enregistrées dans le premier niveau (220) de la cellule à niveaux multiples.

9. Appareil (305) selon la revendication 8, comprenant en outre un lecteur de mémoire (320) pour lire les deuxièmes données à partir d'un deuxième niveau (230) de la cellule à niveaux multiples (120, 130, 215) quand une erreur de calcul a eu lieu.

10. Appareil (305) selon la revendication 8, comprenant en outre un lecteur de mémoire (320) servant à lire les premières données depuis le premier niveau (220) de la cellule à niveaux multiples (120, 130, 215) quand l'erreur de calcul n'a pas eu lieu.

11. Support d'enregistrement lisible par un ordinateur tangible contenant des instructions qui, quand elles sont exécutées, amènent un ordinateur à :
comparer, avec un processeur (310), une version de mémoire globale (205) à une version de mémoire à blocs (210), la version de mémoire globale (205) correspondant à une pluralité de blocs mémoire (208) d'une mémoire à version utilisant une cellule à niveaux multiples (120, 130, 215), la version de mémoire à blocs (210) correspondant à un bloc mémoire de la pluralité de blocs mémoire (208) ; et
déterminer, en fonction de la comparaison, quel niveau (220, 230) dans une cellule à niveaux multiples (120, 130, 215) d'un des blocs mémoire de la pluralité de blocs mémoire (208) enregistre les données de point de contrôle.

12. Support d'enregistrement lisible par un ordinateur selon la revendication 11, enregistrant en outre des instructions qui amènent l'ordinateur à écrire les données reçues vers un premier niveau (220) de la cellule à niveaux multiples (120, 130, 215) quand un deuxième niveau (230) de la cellule à niveaux multiples (120, 130, 215) enregistre les données de point de contrôle.

13. Support d'enregistrement lisible par un ordinateur selon la revendication 11, enregistrant en outre des instructions qui amènent l'ordinateur à au moins :
écrire les premières données enregistrées dans un premier niveau (220) de la cellule à niveaux multiples (120, 130, 215) vers un deuxième niveau de la cellule à niveaux multiples (120, 130, 215) ;
écrire les données reçues vers le premier niveau (220) de la cellule à niveaux multiples (120, 130, 215) après avoir écrit les premières données vers le deuxième niveau (230) de la cellule à niveaux multiples (120, 130, 215) ; et
régler la version de mémoire à blocs (210) à la valeur de la version de mémoire globale (205).

14. Support d'enregistrement lisible par un ordinateur selon la revendication 11, enregistrant en outre des instructions qui amènent l'ordinateur à au moins :
détecter un état d'erreur des données enregistrées dans la cellule à niveaux multiples (120, 130, 215) ; et
lire les données enregistrées dans un niveau de point de contrôle de la cellule à niveaux multiples (120, 130, 215) pour récupérer depuis l'état d'erreur.
